# EUROPEAN PATENT APPLICATION

(11) **EP 4 142 445 A1**
(43) Date of publication of application: **01.03.2023**
(21) Application number: 21793574.1
(22) Date of filing: 07.04.2021
(51) Int. Cl.: H05K 7/20, H02J 50/10

(54) **ELECTRONIC DEVICE COMPRISING HEAT DISSIPATION SHEET**

(30) Priority: 23.04.2020 KR 20200049637
(71) Applicant: Samsung Electronics Co., Ltd., Gyeonggi-do 16677 (KR); Amotech Co., Ltd., Incheon 21629 (KR)
(72) Inventor: YUN, Hajoong, Suwon-si Gyeonggi-do 16677 (KR); KIM, Jinmyoung, Incheon 21629 (KR); LEE, Jinhyoung, Incheon 21629 (KR); KANG, Seunghoon, Suwon-si Gyeonggi-do 16677 (KR); KOO, Kyungha, Suwon-si Gyeonggi-do 16677 (KR); MOON, Hongki, Suwon-si Gyeonggi-do 16677 (KR); PARK, Yoonsun, Suwon-si Gyeonggi-do 16677 (KR); YANG, Seyoung, Suwon-si Gyeonggi-do 16677 (KR)
(74) Representative: HGF
(86) International application number: PCT/KR2021/004364
(87) International publication number: WO 2021/215708

(57) **Abstract**

An electronic device according to various embodiments of the present disclosure may comprise: a housing comprising a front plate and a rear plate; a printed circuit board disposed between the front plate and the rear plate; a wireless charging coil disposed between the printed circuit board and the rear plate; and a heat dissipation sheet disposed between the wireless charging coil and the rear plate. The heat dissipation sheet may comprise a heat dissipation filler comprising: a first heat dissipation filler including a flake-type graphite; and a second heat dissipation filler having an electrical resistance higher than the electrical resistance of the first heat dissipation filler, wherein the weight of the first heat dissipation filler may be 80 wt% to 93 wt% of the whole weight of the heat dissipation sheet.

## Description

### [Technical Field]

Various embodiments of the disclosure relate to an electronic device including a heat dissipation sheet.

### [Background Art]

Electronic devices may output stored information in a form of a sound or an image. In line with the high degree of integration of electronic devices and the widespread use of super-fast large-capacity wireless communication, it has recently become possible to equip a single electronic device, such as a mobile communication terminal, with various functions. For example, not only a communication function, but also an entertainment function such as gaming, a multimedia function such as music/video playback, communication and security functions for mobile banking and the like, a scheduling function, and an electronic wallet function may be integrated into a single electronic device.

Furthermore, a sensor embedded in an electronic device and power supply have increased in importance in order for information and communication devices to be connected and operated with each other regardless of time or place in an information-based society. As the types of mobile devices such as a mobile phone have been rapidly increased in number, charging a battery has required time and effort of users. As a way to address this issue, wireless power transmission technology has recently drawn attention. For example, a wireless power reception device such as a mobile device for wirelessly receiving energy may be driven by the received wireless power or may charge a battery by using the received wireless power and be driven by the charged power.

A wireless power transmission (or wireless energy transfer) technology refers to a technology of wirelessly transferring electrical energy from a transmitter to a receiver by using the principle of magnetic induction. Wireless energy transfer schemes may include a magnetic induction scheme, an electromagnetic resonance scheme, and a power transmission scheme using a short-wavelength radio frequency.

### [Detailed Description of the Invention]

### [Technical Problem]

An electronic device having a communication function, such as mobile terminals, is becoming compact in size and light in weight to maximize the user's portability and convenience, and integrated components are being mounted in a small space for high-performance. Accordingly, components used in mobile terminals are developed to have high performance and thus have increased heating temperatures. The increased heating temperature influences adjacent components and thus cause degradation of the overall performance of the mobile terminals. In addition, when a battery is charged by using wireless power, components of an electronic device may increase in temperature. A dissipation sheet to improve the performance degradation caused by the heating is disposed closer to the outer surface of an electronic device, and thus the heat may be efficiently dispersed. However, generally, a material having thermal conductivity may have low electrical resistance and thus when the heat dissipation sheet having high thermal conductivity is located outside a wireless charging coil, wireless charging efficiency may be reduced. In addition, when a heat dissipation sheet having a low electrical resistance is used, a dissipation effect of the dissipation sheet may be reduced.

An electronic device according to various embodiments of the disclosure may provide a heat dissipation sheet disposed between a rear plate and a wireless charging coil to effectively disperse heat generated from a heat generation source.

Various embodiments of the disclosure may provide an electronic device including a heat dissipation sheet for improving heat generation inside the electronic device without substantial reduction in wireless charging efficiency.

It should be understood, however, that the present invention is not limited to the above-described embodiments, but may be variously modified without departing from the spirit and scope of the invention.

### [Technical Solution]

An electronic device according to various embodiments of the present disclosure may include a housing including a front plate and a rear plate, a printed circuit board disposed between the front plate and the rear plate, a wireless charging coil disposed between the printed circuit board and the rear plate, and a heat dissipation sheet disposed between the wireless charging coil and the rear plate. The heat dissipation sheet may include a heat dissipation filler including a first heat dissipation filler including flake-type graphite, and a second heat dissipation filler having an electrical resistance higher than the electrical resistance of the first heat dissipation filler, wherein the weight of the first heat dissipation filler may be 80 wt% to 93 wt% of the whole weight of the heat dissipation sheet.

The heat dissipation sheet according to various embodiments may include a heat dissipation filler including a first heat dissipation filler including flake-type graphite and a second heat dissipation filler having an electrical resistance higher than the electrical resistance of the first heat dissipation filler, a base resin including synthetic rubber, and a binder for increasing density of the base resin, wherein the weight of the first heat dissipation filler may be 80 wt% to 93 wt% of the whole weight of the heat dissipation sheet.

### [Advantageous Effects]

According to various embodiments, by using a heat dissipation sheet disposed between a rear plate and a wireless charging coil, heat generated from a heat generation source may be effectively dispersed.

An electronic device according to various embodiments of the disclosure may include a high thermal conductivity heat dissipation material and a non-conductive heat dissipation material to have high thermal conductivity while preventing wireless charging efficiency from being degraded.

### [Brief Description of Drawings]

FIG. 1 is a block diagram illustrating an electronic device in a network environment according to various embodiments of the disclosure.
FIG. 2 is a front perspective view of an electronic device according to various embodiments of the disclosure.
FIG. 3 is a rear perspective view of an electronic device according to various embodiments of the disclosure.
FIG. 4 is an exploded perspective view of an electronic device according to various embodiments of the disclosure.
FIG. 5 is a projection view of the interior of an electronic device according to various embodiments of the disclosure viewed through the rear surface of the electronic device.
FIG. 6 is a front view of a rear sheet on which a heat dissipation sheet is disposed according to various embodiments of the disclosure.
FIG. 7A and FIG. 7B are views illustrating a first dissipation filler including flake-type graphite according to various embodiments of the disclosure.
FIG. 8 is a graph showing a temperature of an electronic device according to heat conductivity of a heat dissipation sheet.
FIG. 9 is a view of illustrating temperature distribution of an electronic device according to various embodiments of the disclosure.

### [Mode for Carrying out the Invention]

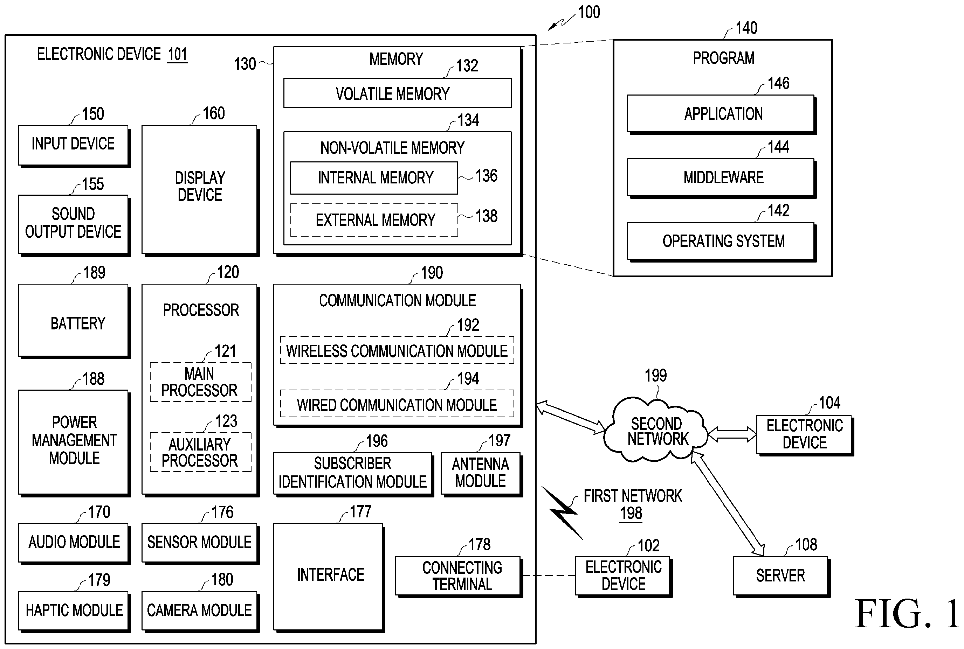

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input device 150 may receive a command or data to be used by a component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, image signal processors, or flashes.

The power management module 188 may manage power supplied to the electronic device 101. According to one embodiment, the power management module 388 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

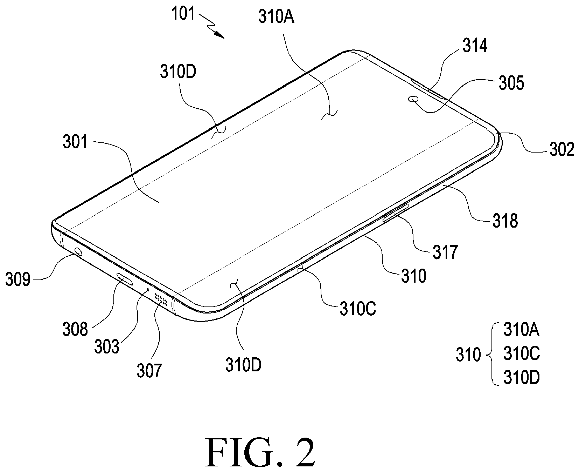

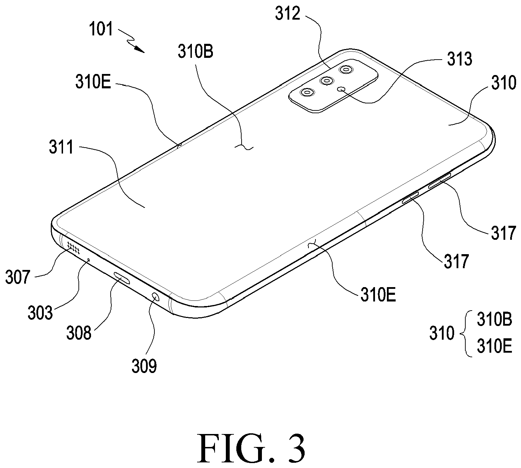

FIG. 2 is a front perspective view of an electronic device 101 according to various embodiments of the disclosure. FIG. 3 is a rear perspective view of an electronic device 101 according to various embodiments of the disclosure.

Referring to FIG. 2 and FIG. 3, the electronic device 101 according to an embodiment may include a housing 310 (e.g., the housing 310 in FIG. 2 to FIG. 3) including a front surface 310A, a rear surface 310B, and a lateral surface 310C (e.g., the lateral surface 310C in FIG. 2 to FIG. 3) surrounding a space between the front surface 310A and the rear surface 310B. According to another embodiment (not shown), the housing 310 may refer to a structure for configuring a portion of the front surface 310A in FIG. 2, and the rear surface 310B and the lateral surface 310C in FIG. 3. According to an embodiment, at least a portion of the front surface 310A may be formed by a substantially transparent front plate 302 (e.g., a glass plate including various coating layers, or polymer plate). The rear surface 310B may be formed by a rear plate 311. The rear plate 311 may be formed by, for example, coated or colored glass, ceramic, polymers, metals (e.g., aluminum, stainless steel (STS), or magnesium), or a combination of at least two thereof. The lateral surface 310C may be coupled to the front plate 302 and the rear plate 311 and formed by a lateral bezel structure (or a "lateral member") 318 including a metal and/or polymer. In an embodiment, the rear plate 311 and the lateral bezel structure 318 may be integrally formed and include the same material (e.g., a metal material such as aluminum, or ceramic).

In the embodiment shown in the drawing, the front plate 302 may include two first edge areas 310D bent toward the rear plate 311 from the front surface 310A to seamlessly extend and disposed at the opposite ends of a long edge of the front plate 302. In the embodiment (see FIG. 3) shown in the drawing, the rear plate 311 may include two second edge areas 310E bent toward the front plate 302 from the rear plate 310B and disposed at the opposite ends of a long edge. In some embodiment, the front plate 302 (or the rear plate 311) may include only one of the first edge areas 310D (or the second edge areas 310E). In another embodiment, a portion of the first edge areas 310D or the second edge areas 310E may not be included. In the embodiments, when viewed from a lateral side of the electronic device 101, the lateral bezel structure 318 may have a first thickness (or width) at a lateral surface in which the first edge areas 310D and the second edge areas 310E are not included, and may have a second thickness thinner than the first thickness at a lateral surface in which the first edge areas 310D and the second edge areas 310E are included.

According to an embodiment, the electronic device 101 may include at least one of a display 301, an audio module 303, 307, 314 (e.g., the audio module 170 of FIG. 1), a sensor module (e.g., the sensor module 176 of FIG. 1), a camera module 305, 312, a key input device 317 (e.g., the input module 150 of FIG. 1), and a connector hole 308, 309 (e.g., the connection terminal 178 of FIG. 1). In an embodiment, the electronic device 101 may omit at least one of the components (for example, the connector hole 309) or additionally include another component.

According to an embodiment, the display 301 may be exposed to the outside through, for example, a substantial portion of the front plate 302. In an embodiment, at least a part of the display 301 may be exposed through the front plate 302 configuring the first surface 310A and the first edge areas 310D of the lateral surface 310C. According to an embodiment, an edge of the display 301 may be formed to be substantially identical to a shape of an outer periphery adjacent to the front plate 302. According to another embodiment (not shown), in order to expand an area through which the display 301 is exposed, a gap between an outer periphery of the display 301 and an outer periphery of the front plate 302 may be formed to be substantially identical.

According to an embodiment, the surface (or the front plate 302) of the housing 310 may include a screen display area formed by visually exposing the display 301. By way of example, the screen display area may include the front surface 310A and the first edge areas 310D of the lateral surface.

In another embodiment (not shown), the display 301 may include a recess or an opening formed on a portion of a screen display area thereof (e.g., the front surface 310A, the first edge area 310D), and may include at least one of an audio module 314, a sensor module 304, a light-emitting element (not shown), and a camera module 305 which are aligned with the recess or the opening. In another embodiment (not shown), the display 301 may include at least one of an audio module 314, a sensor module (not shown), a camera module 305, a fingerprint sensor 316, and an light-emitting element (not shown) on the rear surface of the screen display area.

In another embodiment (not shown), the display 301 may be combined with or disposed adjacent to a touch sensing circuit, a pressure sensor for measuring a strength (pressure) of a touch, and/or a digitizer for detecting a magnetic field-type stylus pen.

In an embodiment, at least a portion of the key input device 317 may be disposed on the first edge areas 310D and/or the second edge areas 310E.

According to an embodiment, the audio module 303, 307, 314 may include, for example, a microphone hole 303 and a speaker hole 307, 314. A microphone for obtaining a sound from outside may be disposed in the microphone hole 303 and in another embodiment, multiple microphones may be arranged to detect a direction of a sound. The speaker hole 307, 314 may include an outer speaker hole 307 and a receiver hole 314 used for calling. In an embodiment, the speaker hole 307, 314 and the microphone hole 303 may be implemented into one hole, or a speaker may be included without a speaker hole 307, 314 (e.g., a piezo speaker).

According to an embodiment, a sensor module (not shown) may generate an electrical signal or a data value corresponding to, for example, an internal operation state or external environment state of the electronic device 101. The sensor module (not shown) may include, for example, a first sensor module (now shown) (e.g., a proximity sensor) and/or a second sensor module (not shown) (e.g., a fingerprint sensor) disposed at the front surface 310A of the housing 310, and/or a third sensor module (not shown) (e.g., an HRM sensor) and/or a fourth sensor module (not shown) (e.g., a fingerprint sensor) disposed at the rear surface 310B of the housing 310. In an embodiment (not shown), the fingerprint sensor may be disposed at the rear surface 310B as well as at the front surface 310A (e.g., the display 301) of the housing 310. The electronic device 101 may further include at least one sensor module not shown in the drawings, for example, a gesture sensor, a gyro sensor, an air pressure sensor, a magnetic sensor, an acceleration sensor, a grip sensor, a color sensor, an infrared (IR) sensor, a biometric sensor, a temperature sensor, humidity sensor, or an illuminance sensor (not shown).

According to an embodiment, the camera module 305, 312 may include a first camera module 305 disposed at the front surface 310A of the electronic device 101, and a second camera module 312 and/or a flash 313 disposed on the rear surface 310B. The camera module 305, 312 may include one or more of lenses, an image sensor, and/or an image signal processor. The flash 313 may include, for example, a light-emitting diode or a xenon lamp. In an embodiment, two or more lenses (an infrared camera, and wide-angle and telephoto lens) and image sensors may be arranged on one surface of the electronic device 101.

According to an embodiment, the key input device 317 may be disposed on the lateral surface 310C of the housing 310. According to another embodiment, the electronic device 101 may not include a portion or entirety of the key input device 317 described above, and the omitted key input device 317 may be implemented as various forms such as a soft key on the display 301.

According to an embodiment, the light emitting element (not shown) may be disposed on, for example, the front surface 310A of the housing 310. The light emitting element (not shown) may provide state information of the electronic device 101 in a form of light, for example. In another embodiment, the light emitting element (not shown) may provide, for example, a light source linked to an operation of the camera module 305. The light emitting element (not shown) may include, for example, a LED, an IR LED, and/or a xenon lamp.

According to an embodiment, the connector hole 308, 309 may include, for example, a first connector hole 308 capable of receiving a connector (for example, a USB connector) for transmitting/receiving power and/or data to/from an external electronic device, and/or a second connector hole 309 (for example, an earphone jack) capable of receiving a connector for transmitting/receiving an audio signal to/from an external electronic device.

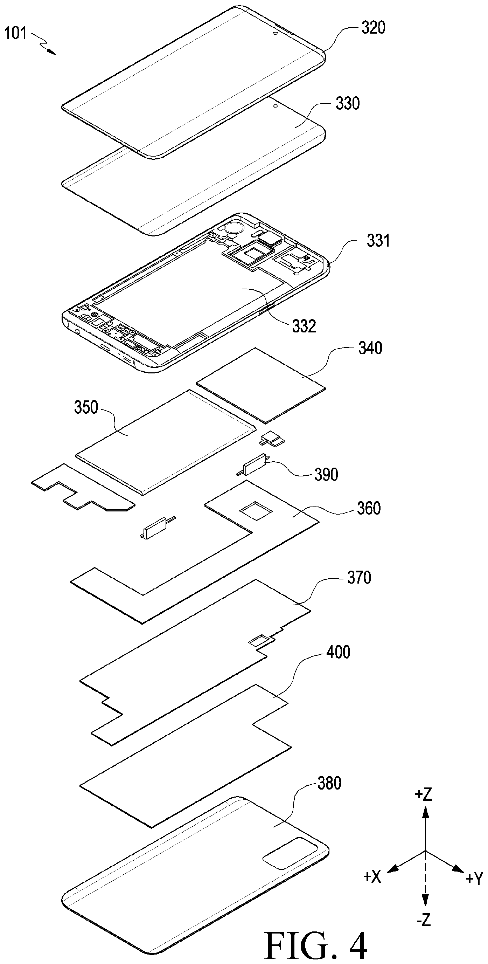

FIG. 4 is an exploded perspective view of an electronic device 101 according to various embodiments of the disclosure.

Referring to FIG. 4, the electronic device 101 (e.g., the electronic device 101 in FIG. 2 or FIG. 3) may include a front plate 320 (e.g., the front plate 302 in FIG. 2), a display 330 (e.g., the display 301 in FIG. 2), a first support member 332 (e.g., a bracket), a main printed circuit board 340, a battery 350, a second support member 360 (e.g., a rear case), an antenna 370, a rear plate 380 (e.g., the rear plate 311 in FIG. 3), an antenna module 390, and a heat dissipation sheet 400. In an embodiment, the electronic device 101 may omit at least one of the components (e.g., the first support member 332 or the second support member 360) or additionally include another component. At least one of the components of the electronic device 101 may be the same as or similar to at least one of the components of the electronic device 101 in FIG. 2 or FIG. 3, and thus the overlapping description thereof will be omitted.

According to an embodiment, the first support member 332 may be disposed in the electronic device 101 to be connected to the lateral bezel structure 331 or integrally formed with the lateral bezel structure 331. For example, the lateral bezel structure 331 may be an edge of the first support member 332 surrounding a lateral surface of the first support member 332. The first support member 332 may be formed of, for example, a metal material and/or a non-metal (e.g., a polymer) material. The first support member 332 may have one surface coupled to the display 330 and the other surface coupled to the printed circuit board 340. A processor, a memory, and/or an interface may be mounted on the printed circuit board 340. The processor may include one or more of, for example, a central processing unit, an application processor, a graphics processing unit, an image signal processor, a sensor hub processor, or a communication processor.

According to an embodiment, the memory may include, for example, a volatile memory or a nonvolatile memory.

According to an embodiment, the interface may include, for example, a high-definition multimedia interface (HDMI), a universal serial bus (USB) interface, an SD card interface, and/or an audio interface. The interface, for example, may electrically or physically connect the electronic device 101 to an external electronic device, and may include a USB connector, an SD card/MMC connector, or an audio connector.

According to an embodiment, the antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may transmit and receive power required for charging or perform near field communication with an external device, for example. For example, the antenna 370 may include a coil for wireless charging. In another embodiment, an antenna structure may be formed of a portion or a combination of the lateral bezel structure 331 and/or the first support member 332.

According to an embodiment, in consideration of transmission/reception characteristics of radio waves, when one antenna module is disposed at a first position on the printed circuit board 340, another antenna module may be disposed at a second position, which is separated from the first position on the printed circuit board 340. As another example, one antenna module and another antenna module may be arranged in consideration of the mutual separation distance according to a diversity characteristic.

According to an embodiment, the antenna module 390 may include a wireless communication circuit that processes radio waves transmitted/received in an ultra-high-frequency band (e.g., 6 GHz or higher and 300 GHz or lower). A conductive plate of the antenna module 390 may include, for example, a patch-type radiation conductor or a conductive plate having a dipole structure extending in one direction and multiple conductive plates may be arrayed to form an antenna array. A chip in which a portion of the wireless communication circuit is implemented (e.g., an integrated circuit chip) may be disposed on one side of the area in which the conductive plate is disposed or on the surface that faces away from the surface on which the conductive plate is disposed, and may be electrically connected to the conductive plate via wiring made of a printed circuit pattern.

According to various embodiments, the heat dissipation sheet 400 may be disposed between the rear plate 380 and the antenna 370. The heat dissipation sheet 400 may disperse heat of the electronic device 101.

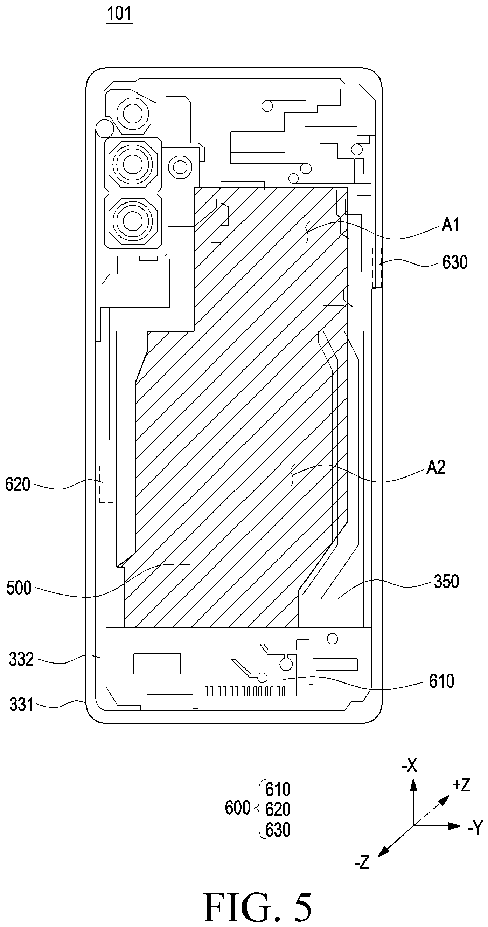

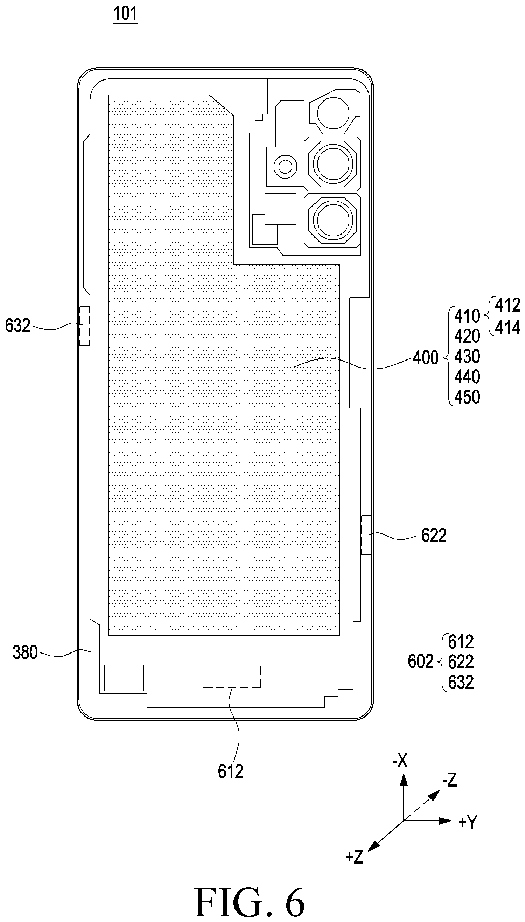

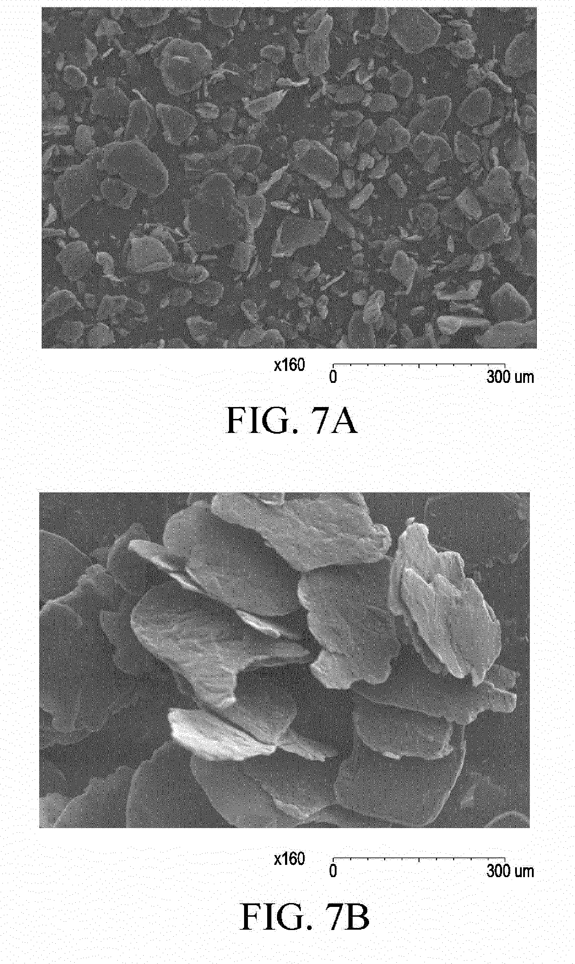

FIG. 5 is a projection view of the interior viewed through the rear surface of the electronic device according to various embodiments of the disclosure. FIG. 6 is a front view of a rear plate on which a heat dissipation sheet is disposed according to various embodiments of the disclosure. FIG. 7A and FIG. 7B are views illustrating a first dissipation filler including flake-type graphite according to various embodiments of the disclosure.

According to FIG. 5, FIG. 6, FIG. 7A, and FIG. 7B, an electronic device (e.g., the electronic device 101 in FIG. 1 to FIG. 4) may include a lateral bezel structure 331, a first support member 332, a rear plate 380, an antenna module 600, a heat dissipation sheet 400, and a wireless charging coil 500. The configuration of the lateral bezel structure 331, the first support member 332, the real plate 380, the antenna module 600, the heat dissipation sheet 400, and the wireless charging coil 500 of FIG. 5 and FIG. 6 may be partially or entirely identical to the configuration of the lateral bezel structure 331, the first support member 332, the real plate 380, the antenna module 390, the heat dissipation sheet 400, and antenna 370 of FIG. 4.

According to various embodiments, the electronic device 101 may receive various electronic components. For example, the electronic device 101 may include a first area A1 in which a printed circuit board (e.g., the printed circuit board 340 in FIG. 4) is received, and a second area A2 in which the battery 350 is received. According to an embodiment, when the electronic device 101 operates, a temperature of the first area A1 having the printed circuit board 340 positioned thereon may be higher than that of the second area A2 having the battery 350 positioned thereon.

According to various embodiments, the heat dissipation sheet 400 may disperse heat incurred inside the electronic device. For example, the electronic device 101 may include high-performance electronic components (e.g., the printed circuit board 340) such as an application processor (AP), a memory, and communication chip, and when electronic components operate, a hot spot area (e.g., the first area A1) where heat is concentrated in a localized area may occur. The heat dissipation sheet 400 may transfer the heat incurred in the hot spot area to an area (e.g., the second area A2 and the outside of the electronic device 101) on which the printed circuit board is not disposed. As the heat of the hot spot area is dispersed through the heat dissipation sheet 400, performance degradation due to overheating of the printed circuit board 340 may be prevented and transmission of high heat to a user body (e.g., a hand grip) may be prevented.

According to various embodiments, the heat dissipation sheet 400 may be disposed between the rear plate 380 and the wireless charging coil 500. For example, the heat dissipation sheet 400 may have a second surface 400b facing a second direction (the -Z direction) and adhesively disposed on the rear plate 380 and a first surface 400a facing a first direction (the +Z direction) and facing at least a portion of the wireless charging coil 500. In case that the heat dissipation sheet 400 is disposed to directly face the rear plate 380 (e.g., FIG. 4), a distance between the heat dissipation sheet 400 and the outside of the electronic device 101 decreases, thereby improving a dissipation effect compared to an electronic device including the heat dissipation sheet 400 under the wireless charging coil 500.

According to various embodiments, the wireless charging coil 500 may wirelessly transmit/receive power required for the battery 350 by using at least one of electromagnetic induction, magnetic resonance, or electromagnetic waves. For example, the wireless charging coil 500 may supply power to the battery 350 based on a magnetic field induced by a magnetic field generated by a coil of an external electronic device. For another example, the wireless charging coil 500 may supply power to an electronic device by generating a magnetic field.

According to various embodiments, the wireless charging coil 500 may cover at least a portion of the battery 350. For example, when viewing the wireless charging coil 500 from the first direction (the +Z direction), the wireless charging coil 500 may overlap at least a portion of the battery 350. As a ratio at which the battery 350 overlaps the wireless charging coil 500 increases, charge efficiency may increase.

According to various embodiments, multiple antenna modules 600 may be arranged to form various directional beams. For example, the antenna module 600 may include at least one of a first antenna module 610, a second antenna module 620, and a third antenna module 630. The first antenna module 610 may be disposed to allow one surface of an antenna radiator to face the rear plate 380 so as to radiate electromagnetic waves toward the rear surface of the electronic device 101. The second antenna module 620 and the third antenna module 630 may be disposed to be spaced apart to radiate electromagnetic waves in different directions (e.g., perpendicular or opposite directions).

According to various embodiments, the antenna module 600 may be disposed on the first support member 332. According to an embodiment, at least a portion of the antenna 600 may be disposed to face at least one rear plate 380. For example, when viewing the electronic device 101 from the second direction (the -Z direction), the antenna module 600 may not overlap the heat dissipation sheet 400 and directly face the rear plate 380.

According to various embodiments, the rear plate 380 may include an antenna-facing area 602 facing the antenna module 600. According to an embodiment, the rear plate 380 may have one area coupled to the heat dissipation sheet 400 and another area facing the antenna-facing area 602. For example, the antenna-facing area 602 may include a first antenna-facing area 612 directly facing the first antenna module 610, a second antenna-facing area 622 directly facing the second antenna module 620, and a third antenna-facing area 632 directly facing the third antenna module 630.

According to various embodiments, the heat dissipation sheet 400 may include a heat dissipation filler 410 configured to disperse heat. For example, the heat dissipation filler 410 may include a first heat dissipation filler 412 having heat conductivity of 100 W/mK to 5000 W/mK or a second heat dissipation filler 414 having heat conductivity of 2 W/mK to 250 W/mK.

According to various embodiments, the first heat dissipation filler 412 may be formed of various materials. For example, the first heat dissipation filler 412 may include at least one of graphite, a carbon fiber, or graphene, and may preferably include graphite.

According to an embodiment, heat conductivity of the heat dissipation sheet 400 may change according to a shape of the graphite included in the first heat dissipation filler 412. For example, the first heat dissipation filler 412 may include flake type graphite.

[Table 1] below shows difference in a temperature of the electronic device 101 including the heat dissipation sheet 400 according to an embodiment of the disclosure and a temperature of an electronic device including another sheet according to comparative examples.

**[Table 1]**

| Classification | Maximum temperature (°C) of P1 | Temperature (°C) of P2 |
|---|---|---|
| Comparative example 1 | 59.9 | 66.2 |
| Comparative example 2 | 57.8 | 65.6 |
| Embodiment 1 | 48.0 | 60.6 |

Referring to [Table 1], a maximum temperature of an area of the heat dissipation sheet 400 according to a shape of a graphite particle may be identified. For example, it may be identified that a heat dissipation effect of the heat dissipation sheet 400 including the first heat dissipation filler 412 formed of flake-type graphite is higher than that of the heat dissipation sheet 400 including the first heat dissipation filler 412 formed of expanded-type graphite. A first position P1 in Table 1, 2, and 4 may be an area of the rear plate 380 adjacent to the printed circuit board 340 and a second position P2 may be the first area A1.

According to an embodiment, the heat dissipation sheet of comparative example 1 may be a general heat dissipation not including graphite. It may be identified that a temperature of a rear plate of an electronic device including the heat dissipation sheet of comparative example 1 is raised to 59.9°C and a temperature of an internal electronic component (e.g., a printed circuit board) is raised to 66.2°C.

According to an embodiment, the heat dissipation sheet of comparative example 2 may be a heat dissipation including expanded-type graphite. It may be identified that a temperature of a rear plate of an electronic device including the heat dissipation sheet of comparative example 2 is raised to 57.8°C and a temperature of an internal electronic component (e.g., a printed circuit board) is raised to 65.6°C.

The heat dissipation sheet 400 (e.g., embodiment 1) according to an embodiment of the disclosure may be a sheet different from the first heat dissipation filler 412 in material compared to comparative example 2. For example, the first heat dissipation filler 412 may include flake-type graphite.

Referring to [Table 1], the heat conductivity of a heat dissipation sheet (e.g., the heat dissipation sheet of embodiment 1) including flake-type graphite may be higher than the heat conductivity of a heat dissipation sheet (e.g., the heat dissipation sheet of comparative example 2) including expanded-type graphite. For example, a sectional area relative to a volume of the flake-type graphite may be smaller than that of the expanded-type graphite. In addition, a packing rate with respect to the heat dissipation 400 including the flake-type graphite may be larger than a packing rate with respect to the heat dissipation sheet 400 including the expanded-type graphite.

According to various embodiments, a particle size of flake-type graphite may be formed in various ways. For example, flake-type graphite may be formed to have a particle size of 50 µm to 100µm, 20 µm to 45 µm, or 20µm to 90µm. Referring to FIG. 7A, the first heat dissipation filler 412 may include flake-type graphite having an average particle size of 60 µm to 120 µm. Referring to FIG. 7B, the first heat dissipation filler 412 may include flake-type graphite having a particle size of 150 µm to 300 µm. According to an embodiment, as the particle size of the flake-type graphite increases, heat conductivity of the heat dissipation filler 410 may increase but electrical resistance may decrease.

[Table 2] below shows temperature difference of the electronic device 101 according to a particle size of flake-type graphite.

**[Table 2]**

| Size of particle (µm) | Maximum temperature (°C) of P1 | Temperature (°C) of P2 |
|---|---|---|
| 50 to 100 | 48.0 | 60.6 |
| 20 to 45 | 51.1 | 61.7 |
| 20 to 90 | 48.8 | 60.5 |

Referring to [Table 2], a maximum temperature of an area of the heat dissipation sheet 400 according to a size of a graphite particle may be identified. The graphite particle may be flake-type graphite. According to [Table 2], as a size of a graphite particle increases, heat conductivity of the heat dissipation sheet 400 may increase.

According to various embodiments, electrical resistance of the second heat dissipation filler 414 may be higher than that of the first heat dissipation filler 412. For example, the second heat dissipation filler 414 may be formed of a substantially non-conductive material (e.g., volume resistance of 10¹³ or more) so that generation of eddy current which reduces charge efficiency of the wireless charging coil 500 may be reduced.

According to various embodiments, the second heat dissipation filler 414 may be formed of various materials. For example, the second heat dissipation filler 414 may include at least one of alumina, boron nitride, yttria, zirconia, aluminum nitride, silicon nitride, silicon carbide, or single crystal silicon. According to an embodiment, the second heat dissipation filler 414 may include alumina or boron nitride.

According to various embodiments, the heat dissipation filler 410 may include a functional heat dissipation material for increasing heat dissipation of the heat dissipation sheet. For example, the heat dissipation filler 410 may include at least one of a carbon nanotube (CNT), a boron nitride nanotube (BNNT), or diamond.

According to various embodiments, the heat dissipation sheet 400 may include a base resin 420. The base resin 420 may be mixed with the heat dissipation filler 410 to form at least a portion of the heat dissipation sheet 400. For example, the base resin 420 may be formed to have a sheet shape after being mixed with the heat dissipation filler 410 through a solvent (e.g., toluene).

According to an embodiment, the base resin 420 may include synthetic rubber. For example, the base resin 420 may include at least one of styrene butadiene rubber (SBR), acryl rubber, or ethylene propylene diene monomer rubber. According to an embodiment, the base resin 420 may be formed of substantially non-conductive (e.g., permittivity of 3.5 or less) material. According to an embodiment, the base resin 420 may include styrene butadien rubber having a low molecular weight among styrene butadien rubbers (SBR).

According to various embodiments, the heat dissipation sheet 400 may include a binder 430. According to an embodiment, the binder 430 may increase density of the base resin 420. For example, the binder 430 may increase a binding force between molecules of the base resin 420 so as to increase density and decrease a thickness of the heat dissipation sheet 400.

According to various embodiments, the binder 430 may be formed of various materials. For example, the binder 430 may be a polyolefine-based binder, an isocyanate-based binder, or a peroxide-based binder, and may preferably be a peroxide-based binder.

[Table 3] below shows a thickness and density of the heat dissipation sheet 400 according to a type of the binder 430.

**[Table 3]**

| Classification | Thickness (µm) | Density (g/cm³) |
|---|---|---|
| Polyolefine-based | 118 | 1.54 |
| Isocyanate-based | 101 | 1.71 |
| Peroxide-based | 82 | 1.81 |

Referring to [Table 3] above, a thickness and density of the heat dissipation sheet 400 according to a type of the binder 430 may be identified. The heat dissipation sheet 400 may include a second heat dissipation filler 414. According to an embodiment, when the heat dissipation sheet 400 including the heat dissipation filler 410 and the base resin 420 includes peroxide-based curing agent 430, the heat dissipation sheet may be reduced in thickness and density, compared with the heat dissipation sheet 400 including another curing agent (e.g., a polyolefine-based curing agent, and an isocyanate-based curing agent). According to various embodiments, the heat dissipation sheet 400 may include a coupling agent 440. The coupling agent 440 may be configured to disperse particles forming the heat dissipation sheet 400. For example, the coupling agent 440 may be applied on the heat dissipation sheet 400 to increase affinity of at least one of the heat dissipation filler 410, the base resin 420, or the binder 430 with a dispersant 450.

According to various embodiments, the coupling agent 440 may include various materials. For example, the coupling agent 440 may include at least one of acetoalkoxy aluminium diisopropylate or isopropyl triisostearoyl titanate.

According to an embodiment, the coupling agent 440 may be disposed on a surface of the heat dissipation sheet 400. For example, the coupling agent 440 may be applied or coated on the heat dissipation sheet 400 formed by mixing the heat dissipation filler 410 and the base resin 420. According to another embodiment, the coupling agent 440 may be mixed together with the heat dissipation filler 410 and the base resin 420 to form the heat dissipation sheet 400.

According to various embodiments, the heat dissipation sheet 400 may include the dispersant 450. The dispersant 450 may reduce surface tension to increase dispersion of the heat dissipation filler 410 and the base resin 420 so as to increase binding force of the heat dissipation filler 410 and the base resin 420 with respect to the coupling agent 440.

[Table 4] below shows a temperature of the rear plate of the electronic device 101 including the coupling agent 440 and the dispersant 450.

**[Table 4]**

| Classification | Maximum temperature (°C) of P1 | Temperature (°C) of P2 | Heat conductivity (W/mK) |
|---|---|---|---|
| Comparative example 3 | 48.0 | 60.6 | 89 |
| Embodiment 2 | 47.8 | 60.9 | 107 |

Referring to [Table 4], the heat dissipation sheet 400 including the coupling agent 440 and the dispersant 450 of comparative example 3 may be the heat dissipation sheet 400 including the first heat dissipation filler 412 including flake-type graphite having a particle size of 50 µm to 100 µm.

The heat dissipation sheet 400 of embodiment 2 may be the heat dissipation sheet 400 including the coupling agent 440 and the dispersant 450. For example, the heat dissipation sheet 400 of embodiment 2 may include the first heat dissipation filler 412 including flake-type graphite having a particle size of 50 µm to 100 µm, the coupling agent 440 including acetoalkoxy aluminium diisopropylate, and the dispersant.

According to various embodiments, the dispersant 450 may increase dispersion of the heat dissipation filler 410 and the base resin 420 to increase heat conductivity of the heat dissipation sheet 400. For example, the heat dissipation sheet 400 of embodiment 2 may have a heat conductivity of about 107 W/mK and the heat dissipation sheet 400 of comparative example 3 may have a heat conductivity of about 89 W/mK.

According to various embodiments, the heat conductivity of the heat dissipation sheet 400 and the efficiency of the wireless charging coil 500 may change based on the rate of the first heat dissipation filler 412. According to an embodiment, the first heat dissipation filler 412 may be a main component of the heat dissipation sheet 400. For example, the first heat dissipation filler 412 may account for 80 wt% to 93 wt% of the total weight of the heat dissipation sheet 400 to reduce efficiency degradation of wireless charging while the heat dissipation sheet 400 is formed to have a heat conductivity of 120 w/mK.

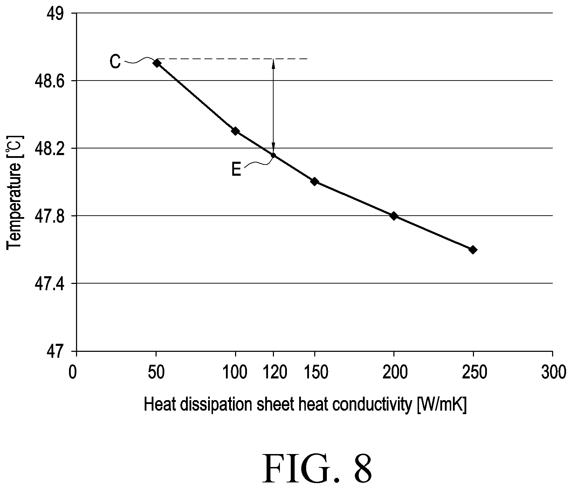

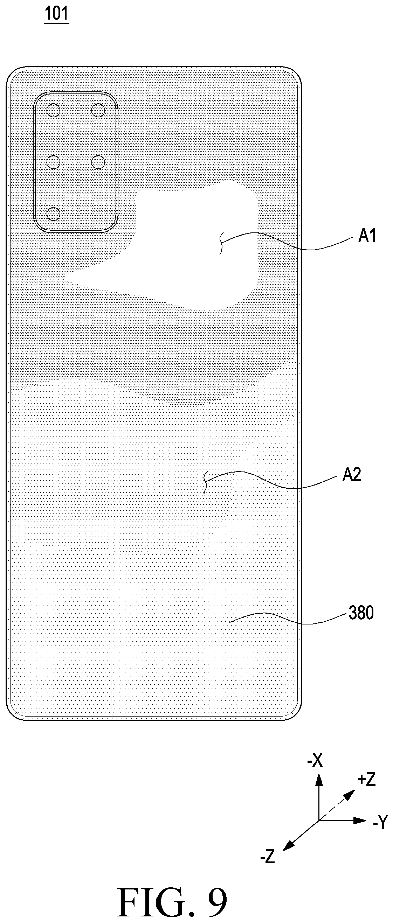

FIG. 8 is a graph showing a temperature of an electronic device according to heat conductivity of a heat dissipation sheet. FIG. 9 is a view of illustrating temperature distribution of an electronic device according to various embodiments of the disclosure.

Referring to FIG. 8, the higher the heat conductivity of the heat dissipation sheet 400, the lower the temperature of the electronic device 101 may be. For example, as the heat conductivity of the heat dissipation sheet 400 increases, heat is dispersed from a printed circuit board (e.g., the printed circuit board 340 in FIG. 4) of the electronic device 101 to the outside of the electronic device 101, and temperatures of the inside (e.g., the printed circuit board 340 in FIG. 4) and a surface (e.g., the rear plate 380) may decrease. According to an embodiment, the electronic device including a low dielectric (e.g., permittivity of about 3.2) heat dissipation sheet having heat conductivity of about 40 W/mK of comparative example 5 may have a temperature of about 50.9°C. According to an embodiment, the electronic device (embodiment 3) including the heat dissipation sheet 400 having heat conductivity of about 120 W/mK may have a temperature of about 49.0°C.

**[Table 5]**

| Classification | Temperature (°C) of P1 | Wireless charging efficiency (%) | Electrical resistance (Ω) | Heat conductivity (W/mK) |
|---|---|---|---|---|
| Comparative example 4 | 52.8 | 80.6 | - | - |
| Comparative example 5 | 50.9 | 80.5 | 10⁶ | 40 |
| Comparative example 6 | - | - | 10⁻⁸ | 400 |
| Comparative example 7 | - | - | 10⁻⁴ | 1500 |
| Embodiment 3 | 49.0 | 79.9 | 4.5 | 120 |

[Table 5] shows wireless charging efficiency of the heat dissipation sheet 400 and a temperature of the electronic device 101 according to various embodiments of the disclosure.

Referring to [Table 5], charging efficiency of the electronic device 101 and a temperature of the electronic device which change according to a type of the heat dissipation sheet may be identified. The temperature may be a temperature of a printed circuit board (e.g., the printed circuit board 340 in FIG. 4) of the electronic device 101. According to an embodiment, as electrical resistance of the heat dissipation sheet increases, the wireless charging efficiency may decrease.

According to an embodiment, the electronic device 101 of comparative example 4 may not include a heat dissipation sheet. Although the wireless charging efficiency of the electronic device not including the heat dissipation sheet is higher than that of comparative example 5 or embodiment 3, the electronic device 101 of comparative example 4 is formed to have a temperature of about 52.8°C and thus overall performance of the electronic device 101 may deteriorate or user inconvenience may occur.

According to an embodiment, the electronic device 101 of comparative example 5 may include a low dielectric (e.g., permittivity of about 4.0 or less) heat dissipation sheet 400. Although the wireless charging efficiency of the electronic device 101 including the low dielectric heat dissipation sheet is higher than that of embodiment 3, the electronic device 101 of comparative example 5 is formed to have a temperature of about 52.8°C and thus overall performance of the electronic device 101 may deteriorate or user inconvenience may occur.

According to an embodiment, the electronic device 101 of comparative example 6 may include the heat dissipation sheet 400 formed of a conductive metal (e.g., copper). The electronic device 101 of comparative example 6 has a high heat conductivity (e.g., 400 W/mK) to increase a heat dissipation effect of the electronic device but has too high electrical resistance (e.g., 10⁻⁸ Ω) to be used for wireless charging.

According to an embodiment, the electronic device 101 of comparative example 7 may include the heat dissipation sheet 400 formed of synthetic graphite. The electronic device 101 of comparative example 7 is formed to have a high heat conductivity (e.g., 1500 W/mK) to increase a heat dissipation effect of the electronic device but has too high electrical resistance (e.g., 10⁻⁴ Ω) to be used for wireless charging.

According to various embodiments, the electronic device 101 of embodiment 3 may be an electronic device 101 including a heat dissipation filler (e.g., the heat dissipation 410 of FIG. 5). According to an embodiment, the electronic device 101 of embodiment 1 may perform wireless charging substantially without wireless charging efficiency reduction (e.g., about 80%). According to an embodiment, the electronic device 101 of embodiment 3 may have a temperature of 50 degrees or less (e.g., about 49.0°C) so that performance degradation of the electronic device 101 or inconvenience of a user may be reduced.

According to FIG. 9, the heat conductivity (e.g., about 50 W/mK) of the electronic device of comparative example 5C may be higher than the heat conductivity (e.g., about 120 W/mK) of embodiment 3E, and the temperature (e.g., about 49.0°C) of the rear plate of the electronic device of comparative example 5C may be higher than the temperature (e.g., about 48.0°C) of the real plate of the electronic device of embodiment 3E.

According to various embodiments of the disclosure, an electronic device (e.g., the electronic device 101 in FIG. 1) may include a housing including a front plate (e.g., the front plate 302 in FIG. 2) and a rear plate (e.g., the rear plate 311 in FIG. 3), a printed circuit board (e.g., the printed circuit board 340 in FIG. 4) disposed between the front plate and the rear plate, a wireless charging coil (e.g., the wireless charging coil 500 in FIG. 5) disposed between the printed circuit board and the rear plate, and a heat dissipation sheet (e.g., the heat dissipation sheet 400 in FIG. 4) disposed between the wireless charging coil and the rear plate, wherein the heat dissipation sheet may include a heat dissipation filler 410 including a first heat dissipation filler (e.g., the first heat dissipation filler 412 in FIG. 5) including flake-type graphite, and a second heat dissipation filler 414 having an electrical resistance higher than the electrical resistance of the first heat dissipation filler, and the weight of the first heat dissipation filler may account for 80 wt% to 93 wt% of the whole weight of the heat dissipation sheet.

According to various embodiments, heat conductivity of the heat dissipation sheet may be 120 W/mK to 600 W/mK.

According to various embodiments, heat conductivity of the first heat dissipation filler may be 100 W/mK to 5000 W/mK, and heat conductivity of the second heat dissipation filler may be 2 W/mK to 250 W/mK.

According to various embodiment, the second heat dissipation filler may include at least one of alumina, boron nitride, yttria, zirconia, aluminum nitride, silicon nitride, silicon carbide, or single crystal silicon.

According to various embodiment, the heat dissipation sheet may include a base resin (e.g., the base resin 420 in FIG. 5) including synthetic rubber and a binder (e.g., the binder 430 in FIG. 5) for increasing density of the base resin.

According to various embodiment, the base resin may include at least one of styrene butadiene rubber (SBR), acryl rubber, or ethylene propylene diene monomer (EPDM) rubber.

According to various embodiments, the binder may be a peroxide-based binder.

According to various embodiments, the heat dissipation sheet may include a coupling agent (e.g., the coupling agent 440 in FIG. 5) configured to increase binding force between the heat dissipation filler and the base resin.

According to various embodiments, the coupling agent may include at least one of acetoalkoxy aluminium diisopropylate or isopropyl triisostearoyl titanate.

According to various embodiments, the heat dissipation sheet may include a dispersant (e.g., the dispersant 450 in FIG. 5) configured to reduce dispersion force of at least one of the heat dissipation filler, the base resin, and the coupling agent.

According to various embodiments, the heat dissipation sheet may include a first surface (e.g., the first surface 400a in FIG. 4) facing the wireless charging coil and a second surface (e.g., the first surface 400b in FIG. 4) facing the rear plate, and the coupling agent may be disposed on at least one of the first surface or the second surface.

According to various embodiments, the heat dissipation sheet may include a carbon nanotube configured to be coupled to the first heat dissipation filler.

According to various embodiments, an average particle size of the flake-type graphite may be 50 µm to 100 µm.

According to various embodiments, the housing may include a lateral member (e.g., the lateral member 318 in FIG. 3) surrounding at least a portion between the front plate and the rear plate and the electronic device may further include an antenna module (e.g., the antenna module 600 in FIG. 5) disposed on the lateral member and including a conductive radiator.

According to various embodiments, when viewing the heat dissipation sheet from above, the heat dissipation sheet may overlap at least a portion of the wireless charging coil and the antenna module may directly face the rear plate.

According to various embodiments of the disclosure, a heat dissipation sheet (e.g., the heat dissipation sheet 400 in FIG. 4) may include a heat dissipation filler (e.g., the heat dissipation filler 410 in FIG. 5) including a first heat dissipation filler (e.g., the first heat dissipation filler 412 in FIG. 5) including flake-type graphite and a second heat dissipation filler (e.g., the second heat dissipation filler 414 in FIG. 5) having an electrical resistance higher than the electrical resistance of the first heat dissipation filler, a base resin (e.g., the base resin 420 in FIG. 5) including synthetic rubber, and a binder (e.g., the binder 430 in FIG. 5) for increasing density of the base resin, wherein the weight of the first heat dissipation filler may be 80 wt% to 93 wt% of the whole weight of the heat dissipation sheet.

According to various embodiments, heat conductivity of the heat dissipation sheet may be 120 W/mK to 600 W/mK.

According to various embodiment, the second heat dissipation filler may include at least one of alumina, boron nitride, yttria, zirconia, aluminum nitride, silicon nitride, silicon carbide, or single crystal silicon.

According to various embodiments, the heat dissipation sheet may further include a coupling agent configured to increase binding force between the heat dissipation filler and the base resin.

According to various embodiments, an average particle size of the flake-type graphite may be 50 µm to 100 µm.

The electronic device including various heat dissipation sheets of the disclosure described above is not limited to the embodiments and drawings described above, and it will be apparent to those of ordinary skill in the art to which the present disclosure pertains that various substitutions, modifications, and changes are possible within the technical scope of the disclosure.

## Claims

1. An electronic device comprising:
a housing comprising a front plate and a rear plate;
a printed circuit board disposed between the front plate and the rear plate;
a wireless charging coil disposed between the printed circuit board and the rear plate; and
a heat dissipation sheet disposed between the wireless charging coil and the rear plate,
wherein the heat dissipation sheet comprises a heat dissipation filler comprising a first heat dissipation filler including flake-type graphite and a second heat dissipation filler having an electrical resistance higher than the electrical resistance of the first heat dissipation filler, and the weight of the first heat dissipation filler is 80 wt% to 93 wt% of the whole weight of the heat dissipation sheet.

2. The electronic device of claim 1, wherein heat conductivity of the heat dissipation sheet is 120 W/mK to 600 W/mK.

3. The electronic device of claim 2, wherein heat conductivity of the first heat dissipation filler is 100 W/mK to 5000 W/ and heat conductivity of the second heat dissipation filler is 2 W/mK to 250 W/mK.

4. The electronic device of claim 1, wherein the second heat dissipation filler comprises at least one of alumina, boron nitride, yttria, zirconia, aluminum nitride, silicon nitride, silicon carbide, or single crystal silicon.

5. The electronic device of claim 1, wherein the heat dissipation sheet comprises a base resin including synthetic rubber and a binder for increasing density of the base resin.

6. The electronic device of claim 5, wherein the base resin comprises at least one of styrene butadiene rubber, acryl rubber, or ethylene propylene rubber.

7. The electronic device of claim 5, wherein the binder is a peroxide-based binder.

8. The electronic device of claim 5, wherein the heat dissipation sheet comprises a coupling agent configured to increase binding force between the heat dissipation filler and the base resin.

9. The electronic device of claim 8, wherein the coupling agent comprises at least one of acetoalkoxy aluminium diisopropylate or isopropyl triisostearoyl titanate.

10. The electronic device of claim 8, wherein the heat dissipation sheet comprises a dispersant configured to reduce dispersion force of at least one of the heat dissipation filler, the base resin, and the coupling agent.

11. The electronic device of claim 8, wherein the heat dissipation sheet comprises a first surface facing the wireless charging coil and a second surface facing the rear plate, and
the coupling agent is disposed on at least one of the first surface or the second surface.

12. The electronic device of claim 1, wherein the heat dissipation sheet comprises a carbon nanotube configured to be coupled to the first heat dissipation filler.

13. The electronic device of claim 1, wherein a particle size of the flake-type graphite is 50 µm to 100 µm.

14. The electronic device of claim 1, wherein the housing comprises a lateral member configured to surround at least a portion between the front plate and the rear plate, and
the electronic device further comprises an antenna module disposed on the lateral member and including a conductive radiator.

15. The electronic device of claim 14, wherein in case that the heat dissipation sheet is viewed from above, the heat dissipation sheet overlaps at least a portion of the wireless charging coil and the antenna module directly faces the rear plate.
